# EUROPEAN PATENT APPLICATION

(11) **EP 4 776 004 A1**
(43) Date of publication of application: **15.07.2026**
(21) Application number: 24862687.1
(22) Date of filing: 29.08.2024
(51) Int. Cl.: G01R 31/12, G01R 31/58

(54) **DISCHARGE DETECTION UNIT**

(30) Priority: 06.09.2023 JP 2023144100; 06.08.2024 JP 2024129647
(71) Applicant: Nitto Kogyo Corporation, Nagakute-shi, Aichi 480-1189 (JP)
(72) Inventor: ITO, Hiroyasu, Nagakute-shi, Aichi 480-1189 (JP); KATO, Koichiro, Nagakute-shi, Aichi 480-1189 (JP); KAKEHI, Tomonori, Nagakute-shi, Aichi 480-1189 (JP); AITA, Yusuke, Nagakute-shi, Aichi 480-1189 (JP); MIYAMOTO, Atsushi, Nagakute-shi, Aichi 480-1189 (JP); SAKAI, Tomoyasu, Nagakute-shi, Aichi 480-1189 (JP); THU HAN, Aye Thu, Nagakute-shi, Aichi 480-1189 (JP)
(74) Representative: Mewburn Ellis LLP
(86) International application number: PCT/JP2024/030879
(87) International publication number: WO 2025/053035

(57) **Abstract**

A discharge detection unit 1 that can detect noise superimposed on a voltage or current of an electric circuit to which the load is connected by being electrically connected to an electric circuit to which a load is connected, the discharge detection unit includes a filter unit 11 that can output a waveform of passed noise in a high frequency band without passing noise at a commercial frequency band and in a low frequency band by cutting noise of a predetermined frequency or lower superimposed on the voltage or current of the electric circuit, a counting unit 12 that can calculate the number of waveform detections in a predetermined time from a waveform passed through the filter unit, and an arithmetic processing unit 13 that can determine presence or absence of noise caused by discharge in the electric circuit using the number of times detected calculated by the counting unit.

## Description

### TECHNICAL FIELD

The present invention relates to a discharge detection unit.

### BACKGROUND ART

As described in Patent Literature 1, there is known a discharge detection device capable of extracting high-frequency discharge noise superimposed on a commercial frequency using a current sensor or a voltage sensor. In the technique disclosed in Patent Literature 1, the constant superimposition of noise when a specific electric drill, a specific mixer, or the like is used for determination of discharge detection. Specifically, the technique disclosed in Patent Literature 1 determines discharge noise by distinguishing a peak time domain including regions before and after a peak at a commercial frequency from a zero-value time domain including regions before and after an output at the commercial frequency is a zero value, and comparing the output at the timing of the peak time domain and the output at the timing of the zero-value time domain.

### CITATIONS LIST

### PATENT LITERATURE

Patent Literature 1: JP 2022-89758 A

Meanwhile, the technique disclosed in Patent Literature 1 is to determine whether the noise output exceeds a threshold. For this reason, in order to distinguish between device noise and discharge noise, a discharge event needs to be large to some extent. In addition, there is a problem that it is difficult to detect the discharge noise generated at a distant place because the noise attenuates as being away from the place where the discharge noise is generated.

### SUMMARY OF INVENTION

### TECHNICAL PROBLEMS

The inventors of the present application have intensively studied this point to attempt to solve the problem. The problem to be solved by the present invention is to enable detection of occurrence of a discharge event even in a situation that has been conventionally difficult to detect.

### SOLUTIONS TO PROBLEMS

In order to solve the above problem, there is provided a discharge detection unit that can detect noise superimposed on a voltage or current of an electric circuit to which a load is connected by being electrically connected to an electric circuit to which a load is connected, the discharge detection unit including a filter unit that can output a waveform of passed noise in a high frequency band without passing noise at a commercial frequency band and in a low frequency band by cutting noise of a predetermined frequency or lower superimposed on a voltage or current of an electric circuit, a counting unit that can calculate a number of waveform detections in a predetermined time from a waveform passed through a filter unit, and an arithmetic processing unit that can determine presence or absence of noise caused by discharge in an electric circuit using a number of times detected calculated by a counting unit.

In addition, preferably, in a case where any one of device noise caused by a load and discharge noise in an electric circuit is generated, it is possible to determine which of device noise and discharge noise is generated by using a number of times detected obtained by a counting unit.

Furthermore, it is preferable to include a setting unit that can set a time during which a number of waveform detections is calculated by a counting unit.

Moreover, preferably, a number of times detected is determined a plurality of times, and in a case where it can be confirmed that a number of times detected is larger than a set number of times for a predetermined consecutive number of times, it can be determined that noise caused by a discharge event is generated.

In addition, preferably, a cause of a discharge event can be specified by using both regularity of appearance of noise during a long period, which is one cycle or more, or regularity of output during a long period, which is one cycle or more, and a number of times detected by a counting unit during a short period, which is shorter than a long period.

Furthermore, preferably, an upper limit on a number of times detected by a counting unit is set, and in a case where a number of times detected exceeding an upper limit is detected, it can be determined as noise caused by an electromagnetic wave.

In addition, preferably, a number of times detected measured by a counting unit can be acquired for each cycle of a voltage or current on which noise is superimposed, and an arithmetic processing unit can determine presence or absence of noise caused by discharge in an electric circuit using at least one or more of an increasing trend of a number of times detected for each cycle and a variation in an increase of a number of times detected for each cycle.

Furthermore, it is preferable to include at least one or more thresholds for a number of times detected measured by a counting unit and at least one or more thresholds for a count measurement time measured by a counting unit, and preferably, an arithmetic processing unit can determine presence or absence of noise caused by discharge in an electric circuit using a threshold for a number of times detected and a threshold for a count measurement time.

Moreover, preferably, there is provided a power distribution system in which the discharge detection unit described above is electrically connected to a plurality of branch breakers, and a relationship between a number of times detected and an occurrence place of a discharge event is stored so as to correspond to a number of branch breakers, and preferably, the power distribution system includes a switch input unit that inputs information of a number of branch breakers or a switch estimation unit that estimates a number of branch breakers, and an occurrence place estimation unit that can estimate an occurrence place of a discharge event using a number of branch breakers input or estimated and a number of times detected measured by a counting unit.

In addition, a relationship between a number of times detected and a frequency is preferably stored, and it is preferable to include a frequency estimation unit that can specify a frequency of a discharge event using a number of times detected measured by a counting unit.

Furthermore, a relationship between a distance between a discharge detection unit and an occurrence place of a discharge event and an attenuation rate is preferably stored for each frequency, and it is preferable to include an occurrence place estimation unit, and an attenuation rate specifying unit that can specify an attenuation rate of discharge noise from a distance of occurrence estimated by a frequency estimation unit and a frequency estimation unit.

### ADVANTAGEOUS EFFECTS OF INVENTION

In the present invention, it is possible to detect the occurrence of the discharge event even in a situation that has been conventionally difficult to detect.

### BRIEF DESCRIPTION OF DRAWINGS

Fig. 1 is a diagram illustrating an example of a discharge event detection system including a discharge detection unit.
Fig. 2 is a diagram illustrating an example in which the discharge detection unit is attached to a distribution board.
Fig. 3 is a schematic diagram illustrating a configuration example of the discharge detection unit.
Fig. 4 is a diagram illustrating superimposition of device noise on a voltage waveform, extraction of a waveform of a specific frequency using a high-pass filter or the like, and illustrating a part of the extracted waveform in an enlarged manner.
Fig. 5 is a diagram illustrating superimposition of discharge noise on a voltage waveform, extraction of a waveform of a specific frequency using the high-pass filter or the like, and illustrating a part of the extracted waveform in an enlarged manner.
Fig. 6 is a diagram illustrating the extracted device noise and the extracted discharge noise side by side.
Fig. 7 is a diagram illustrating an example in which the confirmed voltage output is incorporated in a table.
Fig. 8 is a diagram illustrating an example in which an output value of the discharge noise is small.
Fig. 9 is a diagram illustrating an example in which both the discharge noise and the device noise are generated.
Fig. 10 is a diagram illustrating an example in which 1/4 cycle of a commercial frequency is defined as a time during which counts are integrated.
Fig. 11 is a diagram illustrating an example in which only before and after a peak of the commercial frequency is defined as the time during which counts are integrated. Note that only 1/4 cycle of the commercial frequency is defined as the time during which counts are integrated.
Fig. 12 is a diagram illustrating an example in which two cycles of the commercial frequency are defined as the time during which counts are integrated.
Fig. 13 is a diagram illustrating an example in which it is determined that the discharge noise is generated in a case it is confirmed that the integrated value of counts continuously exceeds a predetermined value. Note that one cycle of the commercial frequency is defined as the time during which counts are integrated.
Fig. 14 is a diagram illustrating superimposition of noise caused by partial disconnection (or disconnection) on a voltage waveform, extraction of a waveform of a specific frequency using the high-pass filter or the like, and illustrating a part of the extracted waveform in an enlarged manner.
Fig. 15 is a diagram in which differences in output waveforms and the like among "device noise", "discharge noise caused by inter-electrode short circuit", and "discharge noise caused by partial disconnection" are organized.
Fig. 16 is a diagram illustrating an example in which an A threshold for distinguishing the device noise from the discharge noise and a B threshold for distinguishing the discharge noise from electromagnetic wave noise or the like are set.
Fig. 17 is a diagram illustrating a determination logic example in a case where the A threshold and the B threshold illustrated in Fig. 16 are set.
Fig. 18 is a diagram illustrating a determination logic example different from that in Fig. 17 in the case where the A threshold and the B threshold illustrated in Fig. 16 are set.
Fig. 19 is a diagram illustrating an example of a temporal change in an integrated value of the number of times detected measured by a counting unit in a case where the device noise is generated. Here, all of five pieces of data have similar temporal changes.
Fig. 20 is a diagram illustrating an example of a temporal change in an integrated value of the number of times detected measured by the counting unit in a case where AC discharge noise is generated. Here, five samples are illustrated.
Fig. 21 is a diagram obtained by adding an arrow indicating the tendency of the temporal change to Fig. 20.
Fig. 22 is a diagram illustrating an example of a temporal change in an integrated value of the number of times detected measured by the counting unit in a case where the AC discharge noise is generated. Here, all of five pieces of data have similar temporal changes.
Fig. 23 is a diagram illustrating an example in which a threshold for the number of times detected is set.
Fig. 24 is a diagram illustrating an example of the relationship among the type of noise, the number of times detected, and a noise measurement time. Here, (a) illustrates a case where the device noise is generated, (b) illustrates a case where the AC discharge noise is generated, and (c) illustrates a case where DC discharge noise is generated.
Fig. 25 is an image diagram illustrating that noise is dispersed caused by the presence of a branch circuit.
Fig. 26 is a diagram illustrating an example of information used in a case of estimating a noise generation point.
Fig. 27 is a diagram illustrating an example of deriving an estimated distance from the number of times detected using the information illustrated in Fig. 26.
Fig. 28 is a diagram illustrating a distribution of the number of times detected at each time within the time during which the number of times detected is integrated. Here, five samples are illustrated.
Fig. 29 is a diagram illustrating an example of the relationship between the number of times detected and a frequency.
Fig. 30 is a diagram illustrating an example in which the data illustrated in Fig. 28 is rewritten using the information illustrated in Fig. 29.
Fig. 31 is a diagram illustrating an example of the relationship between the distance from a generation point to a detection point and an attenuation rate for each frequency.
Fig. 32 is a diagram illustrating an example of deriving the attenuation rate from the distance from the generation point to the detection point using the information illustrated in Fig. 31.
Fig. 33 is a schematic diagram illustrating a configuration example of the discharge detection unit. Here, a second arithmetic processing unit is added to the configuration illustrated in Fig. 3.

### DESCRIPTION OF EMBODIMENT

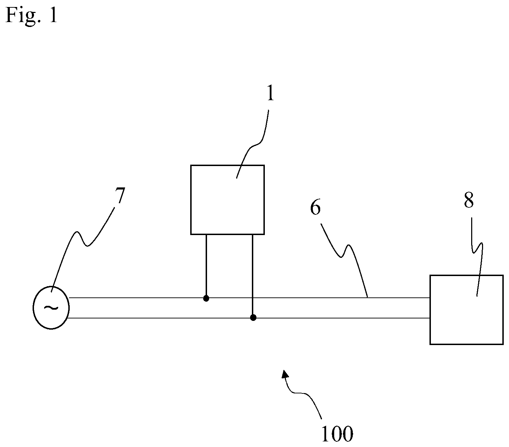

Hereinafter, a mode for carrying out the invention will be described. As can be understood from Figs. 1 to 4, a discharge detection unit 1 of the present embodiment is electrically connected to an electric circuit 6 to which a load 8 is connected, so that noise superimposed on the voltage or current of the electric circuit 6 to which the load 8 is connected can be detected. In addition, the discharge detection unit 1 includes a filter unit 11 capable of outputting a waveform of passed noise in a high frequency band without passing noise at a commercial frequency band and in a low frequency band by cutting noise of a predetermined frequency or lower superimposed on the voltage or current of the electric circuit 6, a counting unit 12 capable of calculating the number of waveform detections in a predetermined time from the waveform passed through the filter unit 11, and an arithmetic processing unit 13 capable of determining the presence or absence of noise caused by discharge in the electric circuit 6 using the number of times detected calculated by the counting unit 12. Therefore, it is possible to detect the occurrence of a discharge event even in a situation that has been conventionally difficult to detect. For example, since the cause can be determined by the number of times detected calculated by the counting unit 12, a small noise can be used for the determination. For this reason, it is possible to suppress the influence of the magnitude and distance of discharge (the influence of attenuation). As a result, it is possible to determine whether or not discharge noise is generated at the initial stage of discharge. In addition, even in a case where the discharge noise is generated at a position slightly away from the discharge detection unit 1, it is possible to determine whether or not the discharge noise is generated.

Here, a discharge event detection system 100 including the discharge detection unit 1 will be described. The discharge event detection system 100 detects an output of noise superimposed on the voltage or current of the electric circuit 6 to which the load 8 is connected. The discharge detection unit 1 is thus connected to the electric circuit 6 interposed between a commercial power supply 7 and the load 8 (see Fig. 1).

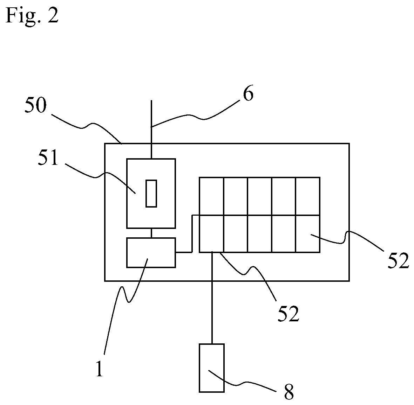

The discharge detection unit 1 is electrically connected to the electric circuit 6 through which electricity flows between the commercial power supply 7 and the load 8, and is attached inside a house, for example. The discharge detection unit 1 may be disposed inside a distribution board 50 (see Fig. 2). This makes it possible to detect the presence or absence of a discharge event in the electric circuit 6 in the house connected to the distribution board 50. For example, it is preferable to connect the discharge detection unit 1 to the electric circuit 6 connecting a main breaker 51 and a branch breaker 52. Here, the discharge detection unit 1 may be electrically connected to the primary side of the main breaker 51 or the secondary side of the branch breaker 52.

Here, the discharge detection unit 1 of the embodiment will be described. The discharge detection unit 1 of the embodiment includes the filter unit 11 so as to be able to cut noise of a predetermined frequency or lower superimposed on the voltage or current of the electric circuit 6. The filter unit 11 can pass noise in a high frequency band without passing noise at a commercial frequency and in a low frequency band. In addition, the discharge detection unit 1 includes a waveform generation unit 15 that generates a noise waveform in a high frequency band having passed through the filter unit 11.

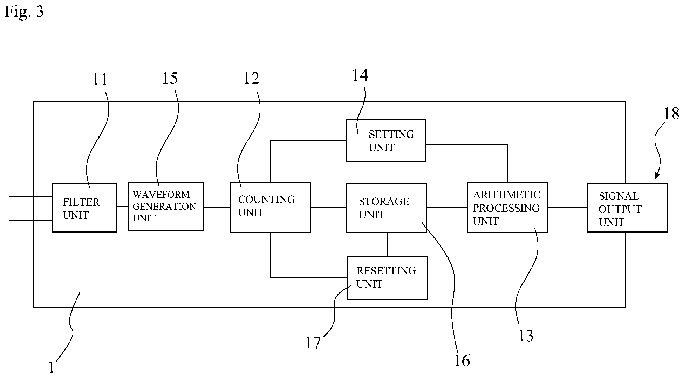

Furthermore, the discharge detection unit 1 includes the counting unit 12 that counts the number of waves generated by the waveform generation unit 15. In addition, the discharge detection unit 1 includes a storage unit 16 that stores the number of wave detections measured by the counting unit 12. The discharge detection unit 1 of the example illustrated in Fig. 3 further includes a resetting unit 17 capable of resetting the count of the counting unit 12 and resetting the information in the storage unit 16. Note that the resetting unit 17 may be able to reset only one of the count of the counting unit 12 and the information in the storage unit 16. In the discharge detection unit 1, the waveform generation unit 15 can be omitted. The discharge detection unit 1 may be configured such that the counting unit 12 counts the output on the basis of the output extracted by the filter unit 11.

In addition, the discharge detection unit 1 includes a setting unit 14 capable of setting a determination condition used in a case where whether or not discharge noise is generated is determined from the number of times detected. The setting unit 14 of the embodiment can be operated to change and reset the determination condition. By providing such a setting unit 14 in the discharge detection unit 1, for example, if the measurement time is set to be short, the measurement can be terminated quickly. Furthermore, if the measurement time is set to be long, the accuracy of the determination of the presence or absence of noise generation can be enhanced.

As can be understood from these descriptions, the discharge detection unit 1 is preferably configured to include the setting unit 14 capable of setting the time for calculating the number of waveform detections in the counting unit 12.

In addition, the discharge detection unit 1 includes the arithmetic processing unit 13 capable of performing an arithmetic operation for determining whether or not discharge noise is generated from the information of the number of times detected and the determination condition. The arithmetic processing unit 13 of the embodiment is a processor, but may be other units as long as the arithmetic operation described above can be performed.

Moreover, the discharge detection unit 1 illustrated in Fig. 3 includes an output unit 18 used to notify the outside of the discharge detection unit 1 of the result of the arithmetic processing unit 13. The output unit 18 may be able to issue a notification using vision. In this case, the output unit 18 may be configured using an LED. Furthermore, the output unit 18 may be able to issue a notification using hearing. In this case, the output unit 18 may be configured using a buzzer. Furthermore, the output unit 18 may output a signal. For example, the output unit 18 can be a signal output unit that outputs a detection result to an external measurement device or an external monitoring device. In addition, the output unit 18 may be a signal output unit capable of outputting a cutoff signal to the main breaker 51 or the branch breaker 52.

Note that the filter unit 11 can extract device noise caused by a device and discharge noise caused by a discharge event. Here, differences in tendency of noise passing through the filter unit 11 between the discharge noise and the device noise will be described.

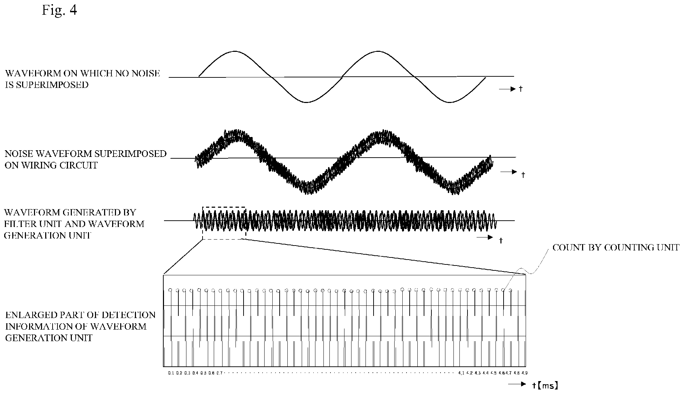

First, a case where the device noise is extracted by the filter unit 11 will be described (see Fig. 4). Note that handling of a current waveform on which noise is superimposed and handling of a voltage waveform on which noise is superimposed are similar, and thus the voltage waveform on which noise is superimposed will be described as an example.

In a case where no noise is superimposed, the voltage waveform repeats a constant waveform in accordance with the frequency of the commercial power supply 7. As can be understood from Fig. 4, in a case where the device noise is superimposed, the noise overlaps regardless of the position of the waveform of the commercial power supply 7. For this reason, in the example illustrated in Fig. 4, a small wave caused by the device noise always overlaps a large wave indicated by the voltage waveform caused by the commercial power supply 7.

When the device noise is extracted using the filter unit 11 and the waveform generation unit 15, the influence of the waveform of the commercial power supply 7 is eliminated, and a waveform caused by the device noise is generated. That is, the waveform of only the noise output is generated by cutting the output of the commercial frequency from the voltage waveform using the filter unit 11. The number of waveform outputs of the waveform of only the noise output is counted by the counting unit 12.

Here, specific examples will be described using numerical values. For example, the device noise caused by the operation of the device is noise mainly caused by switching between ON and OFF operations. Noise caused by this switching is several k to several tens kHz. Note that the frequency indicates the number of times a wave repeats in a second, and thus the switching noise generated at 10 kHz is output at intervals of 1/10000s=0.1 ms. In addition, in a case where the commercial frequency is 60 Hz, the time of one cycle is 16.7 ms, and thus the wave is output 167 (=16.7 ms/0.1 ms) times in one cycle by switching.

Next, the discharge noise will be described. Discharge noise in an inter-electrode short circuit such as tracking occurring between electrodes is detected in a frequency band (for example, a megahertz or gigahertz level) having a different order of magnitude from the frequency of switching noise (for example, a kilohertz level).

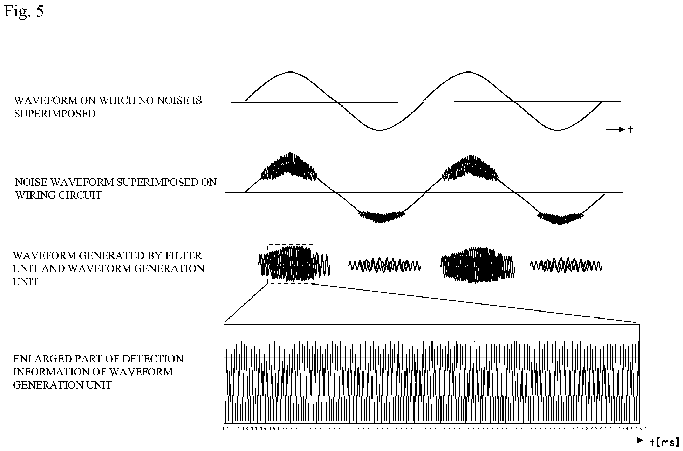

To give a specific example, assuming that noise in a target discharge event is generated in a frequency band of 1 MHz, in a case where the commercial frequency is 60 Hz, waves may be generated caused by the discharge event at such a pace that the wave is output 16700 (=16.7 ms/0.001 ms) times in one cycle. Here, the discharge noise is not detected in the vicinity of the zero crossing point (see Fig. 5). That is, since this value is not continuously detected during one cycle, what can be detected is a smaller value than this.

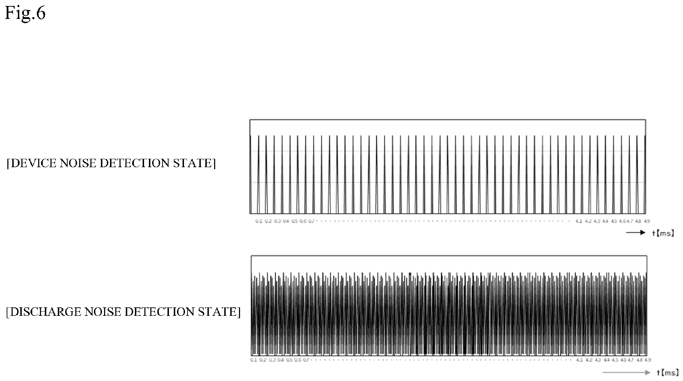

As described above, the noise in the discharge event is detected only in the vicinity of the peak region of the commercial frequency, and is not detected in the vicinity of the zero crossing point such as a zero-value time domain. However, even if the discharge noise is output in half a cycle, several thousands to several tens of thousands of waves are superimposed. On the other hand, the device noise is a noise output in which several hundred waves are superimposed in one cycle. That is, the number of times detected obtained per unit time is considerably different between the noise in the discharge event and the device noise, and it is possible to determine whether the noise is the discharge noise or the device noise (the switching noise) (see Fig. 6).

Specifically, the number of wave detections in one cycle in a case where the device noise is generated is, for example, 167, and the number of wave detections in one cycle in a case where the discharge noise is generated is, for example, 8350, which is half of 16700. Focusing on such a difference, it is configured in the embodiment that the setting unit 14 sets a threshold for the number of wave detections measured by the counting unit, and the arithmetic processing unit 13 determines whether the noise is the device noise or the discharge noise using the set threshold.

Note that, in the above example, the description has been given assuming that the switching noise is generated at several tens kHz and the discharge noise is generated at several MHz, but the determination is not limited to these frequency bands.

Furthermore, in the embodiment, in a case where noise is present, the number of times detected per cycle is counted by the counting unit 12 regardless of the magnitude (magnitude) of the noise, and the result is stored in the storage unit 16. The number of times detected stored in the storage unit 16 is compared with the threshold for the number of times detected set by the setting unit 14, and whether the device noise or the discharge noise is generated is determined using the arithmetic processing unit 13. In this way, by confirming the number of waves, it is possible to determine whether the noise is caused by the discharge event or the noise is caused by the device.

As can be understood from these descriptions, it is preferable that the discharge detection unit 1 be configured to be able to determine which one of the device noise caused by the load 8 and the discharge noise in the electric circuit 6 is generated by using the number of times detected obtained by the counting unit 12.

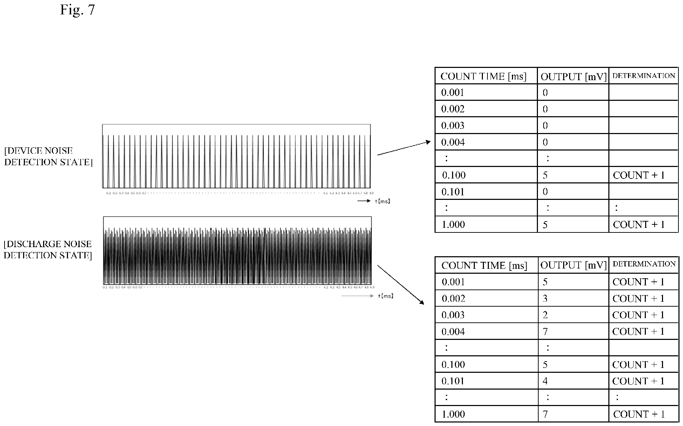

The counting method performed by the counting unit 12 may be any method, and for example, the presence or absence of the voltage output at each time is confirmed using a matrix (see Fig. 7). In the example illustrated in Fig. 7, processing is performed so as to increase the number of times detected by one every time an output of a specific value or more is confirmed.

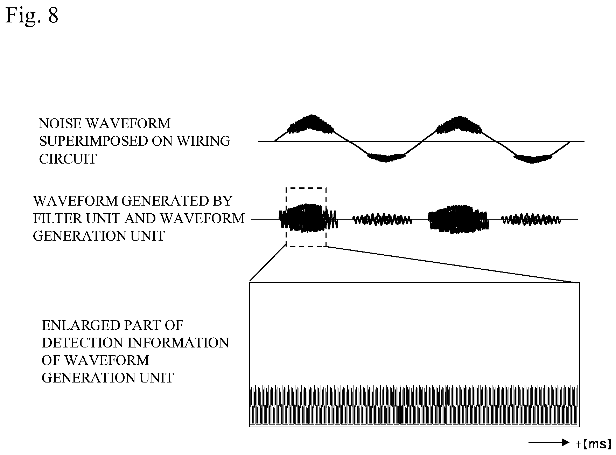

Here, an example of detection of the discharge noise in the inter-electrode short circuit will be described. With respect to the discharge noise in the inter-electrode short circuit, there is a tendency that the output value of the discharge noise is detected to be small in a case where the measurement position is away from the generation point or in the initial stage of discharge (see Fig. 8). However, even if the detection value of the noise is small, the number of times can be confirmed. Therefore, in determining noise, it is possible to suppress the influence of the distance between the generation point and the measurement position, the smallness of the generated noise, and the like. That is, even in a case where the distance between the discharge detection unit 1 and the generation position of the discharge event is long or even in a case where the noise is at an initial stage, it is possible to determine the discharge noise.

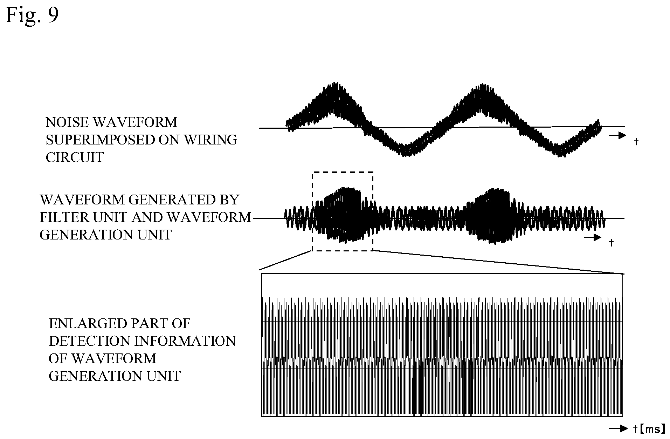

It is also conceivable that the discharge noise and the device noise are mixed (see Fig. 9). In this case, it is difficult to consider the device noise and the discharge noise separately, but it is possible to determine the presence or absence of the discharge noise from the count size. That is, even in a case where the discharge noise and the device noise are mixed, it is possible to determine whether the discharge noise is generated using the number of times detected. Whether or not the device noise is generated is not so important, and whether or not the discharge noise is generated is important. Therefore, the most necessary information can be obtained without separating the device noise and the discharge noise.

In this example, the count value is handled on the basis of one cycle. For example, in a case where no noise is detected in one cycle, or in a case where a predetermined number or more of noises are not detected, it is configured that the resetting unit 17 resets the count of the counting unit 12, and the count is performed again from the beginning.

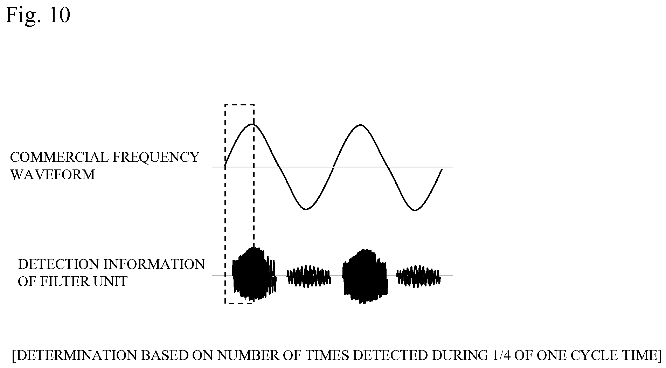

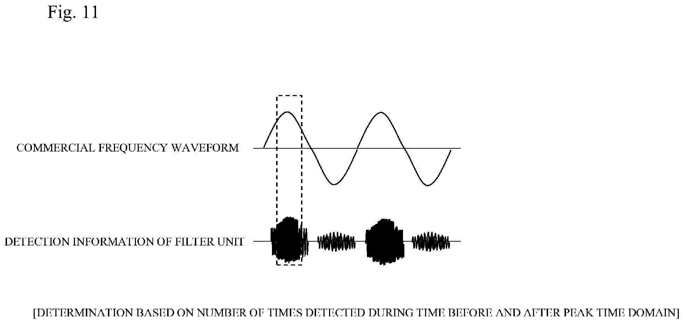

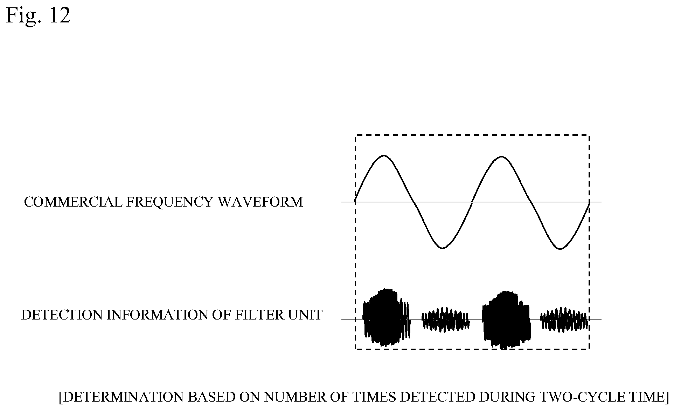

Note that the number of waves in one cycle time (about 16.7 ms for 60 Hz) has been detected so far, but the time during which the number of waves is measured is not limited to one cycle. For example, the number of waves in 1/4 cycle time (about 4.2 ms for 60 Hz) may be measured instead of one cycle time (see Fig. 10). In addition, since the discharge noise is detected to be large before and after the peak of the current or voltage at the commercial frequency, only before and after the peak time of the commercial frequency waveform may be measured (see Fig. 11). Moreover, in order to enhance the accuracy of distinguishing the device noise from the discharge noise, the number of waves in two-cycle time (about 33.4 ms for 60 Hz) may be measured (see Fig. 12). Needless to say, it is not limited to these cycle times.

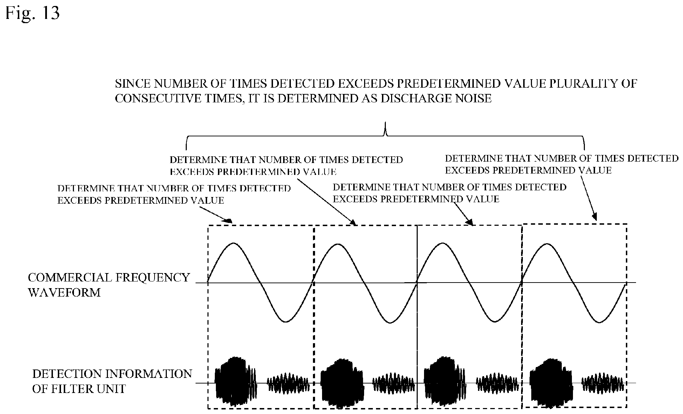

Note that the number of times detected may increase caused by an instantaneous trouble. Therefore, in a case where the presence or absence of the discharge event is determined by a number of times detected in one cycle time of one or the like, it is determined that the discharge event occurs even if such a situation occurs. For this reason, it is conceivable to determine whether or not the number of times detected exceeds a predetermined number of times every predetermined time (for example, one cycle). In this case, when "the number of times detected exceeds a predetermined number of times" for a plurality of consecutive times (a plurality of times), it may be determined as the discharge noise (see Fig. 13). In this way, the possibility of erroneous detection caused by an instantaneous trouble can be suppressed. That is, it is possible to more accurately determine whether or not it is the discharge noise. Note that in a case where it is determined whether or not when "the number of times detected exceeds a predetermined number of times" for a plurality of consecutive times (a plurality of times), when the state where "the number of times detected exceeds a predetermined number of times" continues a plurality of times, even if the number of times detected does not exceed the predetermined number of times during a predetermined time (for example, one cycle), when "the count exceeds the predetermined number of times" again in the measurement time of the next one cycle, it may be determined that the state is continuous.

For example, in a case where it is determined that noise is generated when "the number of times detected exceeds a predetermined number of times" for four consecutive times, assuming that "the number of times detected exceeds a predetermined number of times" for three consecutive times, but "the number of times detected exceeds a predetermined number of times" at the next timing, and then "the number of times detected exceeds a predetermined number of times" at the next timing. In such a case, it is determined that noise is generated because "the number of times detected exceeds a predetermined number of times" for four consecutive times.

As can be understood from these descriptions, it is preferable that the discharge detection unit 1 be configured to determine the number of times detected a plurality of times, and when it can be confirmed that the number of times detected is larger than the set number of times for a predetermined consecutive number of times, to be able to determine that the noise caused by the discharge event is generated. This is because the generation of discharge can be determined more accurately.

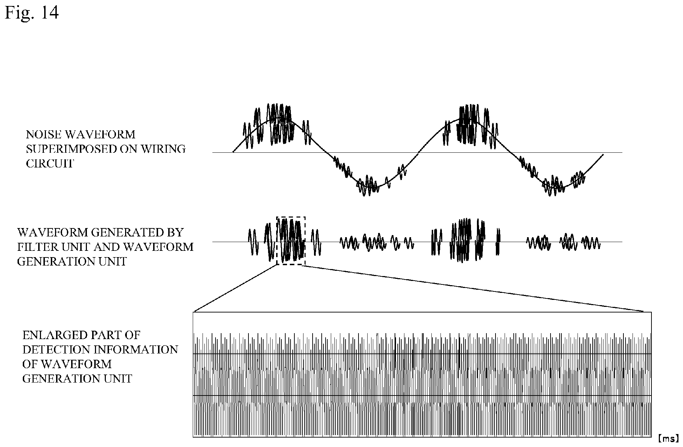

Next, the discharge noise caused by partial disconnection will be described. The generation of discharge is caused not only by the inter-electrode short circuit but also by the partial disconnection (or disconnection) at the same electrode. In the case of the partial disconnection (or disconnection), lines are repeatedly connected and disconnected to and from each other to lead to sparks, resulting in irregular output (see Fig. 14). Here, the discharge noise caused by the partial disconnection (or disconnection) is generated in a frequency band similar to that of the discharge noise caused by the inter-electrode short circuit. In addition, the number of times detected is different from that of the device noise as in the inter-electrode short circuit. Therefore, by using the number of times detected, it is possible to determine whether or not the discharge noise caused by the partial disconnection (or disconnection) is possibly generated regardless of whether or not the device noise is generated.

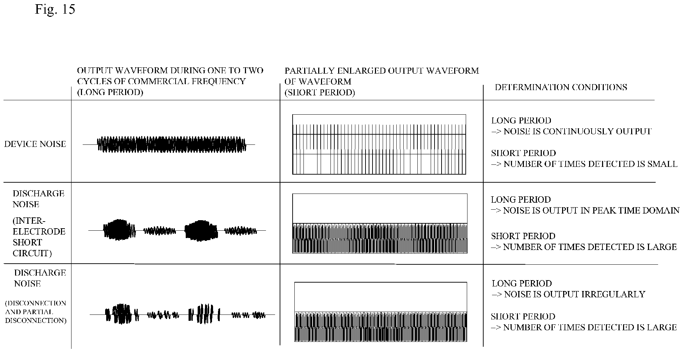

Here, differences in output waveforms and the like among "device noise", "discharge noise caused by inter-electrode short circuit", and "discharge noise caused by partial disconnection" will be organized. The device noise and the discharge noise (caused by the inter-electrode short circuit, the partial disconnection, and the like) behave as illustrated in Fig. 15, for example. Therefore, it is possible to make a determination to distinguish the device noise from the discharge noise by using the number of noise detections per unit time.

In addition, the type of the discharge noise can also be determined by using the regularity of a noise output waveform during a long time (one to two cycles).

For example, the output waveform is confirmed during one to two cycles, and if it is confirmed that noise is continuously output during that time, it can be determined that the device noise is generated. Note that when a part of one cycle is extracted and it is confirmed that the number of times detected is small, it may be determined as the device noise, but it may be determined as the device noise in a case where both the continuity of noise output and the number of times detected satisfy conditions. For example, it may be determined as the device noise by confirming both that noise is continuously output during half a cycle or more and that the number of times detected is small.

On the other hand, for example, in a case where the output waveform is confirmed during a cycle or more and it is found that noise is continuously output in a peak time domain but no noise is output in the vicinity of the zero crossing point, it may be determined that the discharge noise caused by the inter-electrode short circuit is generated. Needless to say, it may be determined that the discharge noise caused by the inter-electrode short circuit is generated after confirming that the number of times detected is large.

In addition, in a case where noise is output without regularity, it may be determined that the discharge noise caused by the partial disconnection (or disconnection) is generated. Needless to say, it may be determined that the discharge noise caused by the partial disconnection (or disconnection) is generated after confirming that the number of times detected is large.

That is, the type of noise may be determined by using not only one of the appearance of the noise of the output waveform during a long period (for example, during the time of one to two cycles of the commercial frequency) and the output waveform during a short period (for example, 1 ms) but also the detection results of both of them. Note that the long period is preferably one cycle or more, and the short period is preferably less than one cycle. These long and short periods of time are not limited to the above, but they are different periods of time.

As can be understood from these descriptions, the discharge detection unit 1 is preferably configured to be able to specify the cause of the discharge event by using both the regularity of the appearance of noise during the long period, which is one cycle or more, or the regularity of output during the long period, which is one cycle or more, and the number of times detected by the counting unit 12 during the short period, which is shorter than the long period.

Note that when the number of times detected exceeds a predetermined value set by the setting unit 14, it may be determined that the noise caused by the discharge event is generated, but an electromagnetic wave or the like is in a frequency band having an order of magnitude larger than the frequency band corresponding to the discharge noise, and there is a possibility that noise in such a frequency band may be generated depending on an installation location. In this case, for example, in a case where the number of times detected is a predetermined number or more (for example, a million counts in one cycle), it means that an output that is not the discharge noise is detected.

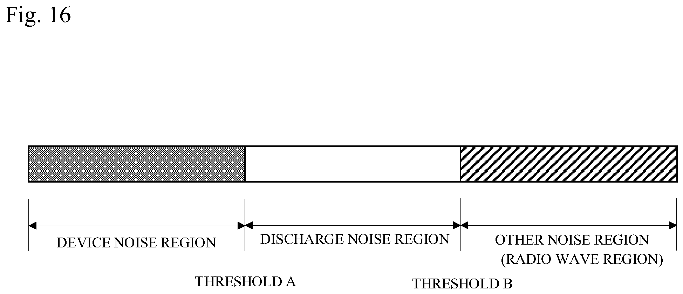

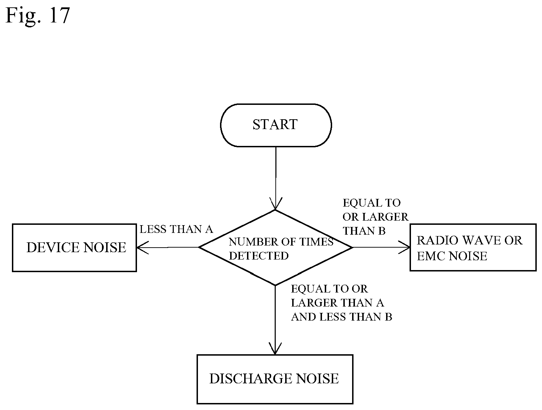

Therefore, it is preferable to set a lower limit (an A threshold) and an upper limit (a B threshold) in the threshold for the number of times detected (see Fig. 16). In this case, for example, it is conceivable that when the number of times detected is less than the lower limit (less than the A threshold), it is determined as the device noise, when the number of times detected is equal to or larger than the upper limit (equal to or larger than the B threshold), it is determined as radio wave noise or electromagnetic wave noise (EMC noise), and when the number of times detected is equal to or larger than the lower limit and less than the upper limit, it is determined as the discharge noise (see Fig. 17).

Meanwhile, even if the lower limit (the A threshold) and the upper limit (the B threshold) are set, the device noise falling within the B threshold from the A threshold may be generated. In view of this, it is further conceivable to incorporate another step.

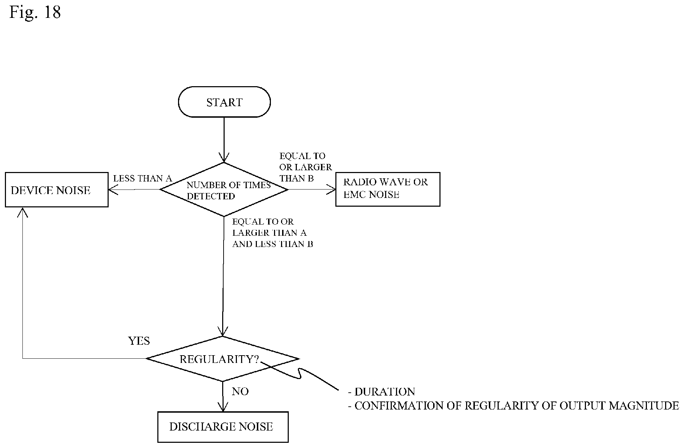

For example, the device noise is mainly switching noise, and the duration of the noise and the magnitude of the output have regularity. On the other hand, in the case of the discharge noise, the appearance of the noise is not uniform, for example, the magnitude of output varies. Therefore, it is conceivable to incorporate a step of confirming regularity (see Fig. 18). Note that the upper limit range is not necessarily required in the case of use in an environment in which noise in a frequency band having an order of magnitude larger than the frequency band corresponding to the discharge noise is not generated.

As understood from these descriptions, it is preferable that the discharge detection unit 1 be configured to have an upper limit on the number of times detected by the counting unit 12, and to be able to determine that it is the noise caused by the electromagnetic wave in a case where the number of times detected exceeding the upper limit is detected.

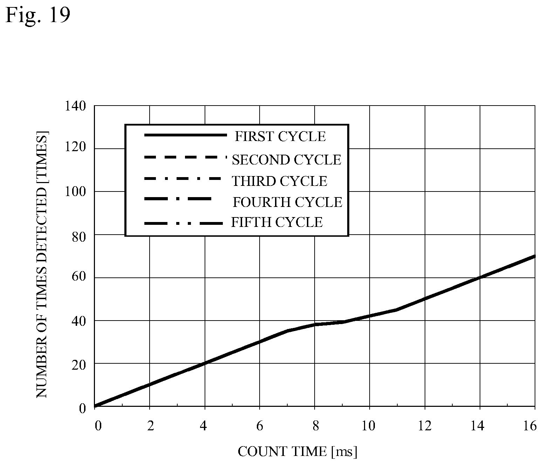

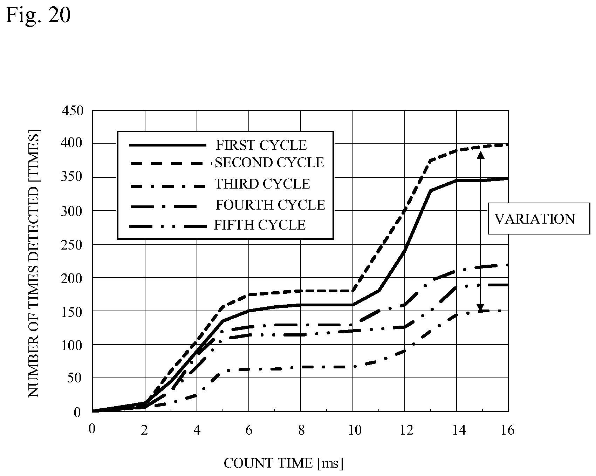

Meanwhile, most of the device noise is switching noise, and is output at regular intervals. In addition, since the switching noise does not change depending on the voltage and current, when the number of times detected is integrated, the relationship between the time and the integrated number of times detected is proportional. Such a tendency basically does not change in any cycle (see Fig. 19). On the other hand, in the case of the discharge noise, the magnitude of the discharge event (the magnitude of the current and voltage) and the presence or absence of the discharge event are not constant, and thus the increasing tendency of the number of times detected differs for each cycle (see Fig. 20).

That is, it is possible to estimate whether the noise is the device noise caused by the operation of the device or the discharge noise caused by discharge by acquiring a plurality of integrated values of the number of times detected in a certain period of time and comparing them. For example, it is possible to acquire a plurality of integrated values of the number of times detected in one cycle of the voltage or current on which noise is superimposed, estimate that the noise is the device noise in a case where the variation is small, and estimate that the noise is the discharge noise in a case where the variation is large.

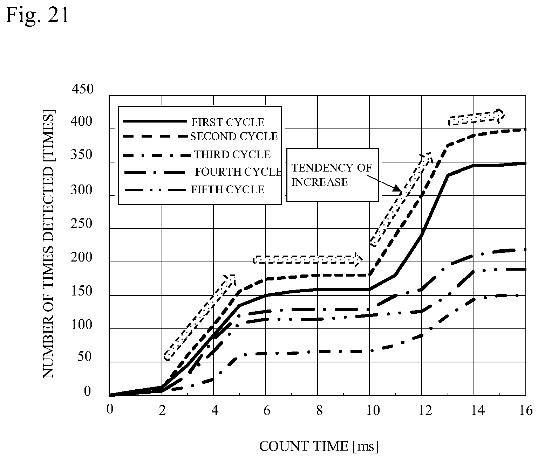

In addition, as understood from Figs. 19 and 20, in the case of the device noise, the integrated value of the number of times detected and the time are in a substantially proportional relationship, but in the case of the discharge noise, such a case does not occur. More specifically, in the case of the discharge noise, when looking at the integrated value of the number of times detected in one cycle of the voltage or current on which noise is superimposed, it can be found that there are a time period in which the integrated value rapidly increases and a time period in which the integrated value stagnates (see Fig. 21). In addition, it can be found that the time period in which the integrated value rapidly increases appears twice in one cycle. This is because the discharge noise is detected in the vicinity of the peak region of the commercial frequency, but is hardly detected in the zero-value time domain. Note that it cannot be understood from what is illustrated in Fig. 21, the noise generation time in the vicinity of the peak region usually changes depending on the magnitude of discharge.

As can be understood from these descriptions, the device noise and the discharge noise have different increasing tendencies in the integrated value of the number of times detected in a certain period of time of the voltage or current on which noise is superimposed. Therefore, by confirming the increasing tendency of the integrated value of the number of times detected, it is possible to estimate whether it is the device noise or the discharge noise. For example, an increase in the integrated value of the number of times detected in one cycle of the voltage or current on which noise is superimposed is checked, and in a case where the integrated value is proportional to time, it can be estimated as the device noise, and in a case where the integrated value is not proportional to time, it can be estimated as the discharge noise. Note that the difference in increasing tendency can be confirmed only by making a check in half a cycle of the voltage or current on which noise is superimposed.

As can be understood from these descriptions, only one of "variation in integrated value of counts" and "tendency of increase in integrated value of counts" may be checked and made use of to estimate the device noise and the discharge noise, or both may be checked and made use of to estimate the device noise and the discharge noise. In order to enable such a configuration, it is preferable that the number of times detected measured by the counting unit can be acquired for each cycle of the voltage or current on which noise is superimposed, and the arithmetic processing unit can determine the presence or absence of the noise caused by discharge in the electric circuit using at least one or more of the increasing trend of the number of times detected for each cycle and the variation in the increase of the number of times detected for each cycle.

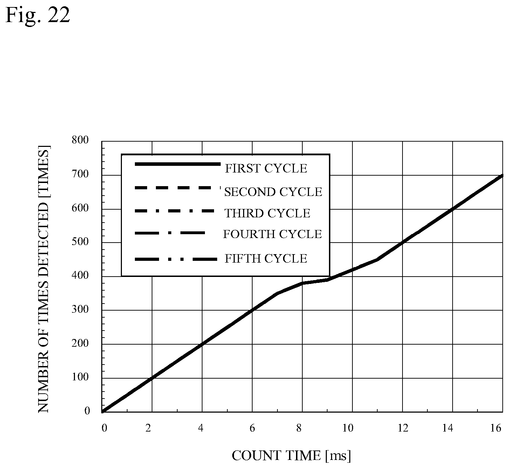

Although the example of detection of the discharge event in the AC system has been described above, the discharge event also occurs in the DC system. In the DC system, when noise is superimposed on the voltage output or current output of the wiring circuit, the integrated value of the number of times detected and the time have a substantially proportional relationship (see Fig. 22). Here, the number of times detected is considerably larger than that in a case where the device noise is generated, and the integrated value thereof is also large. This is because noise is always output at a high frequency. As a result, the number of discharge noise detections in a case where the discharge event occurs in the DC system is larger than the number of discharge noise detections in the AC system.

As understood from these descriptions, by using the number of times detected acquired by the counting unit, it is possible not only to distinguish the device noise from the discharge noise, but also to distinguish whether the discharge noise is AC discharge noise or DC discharge noise.

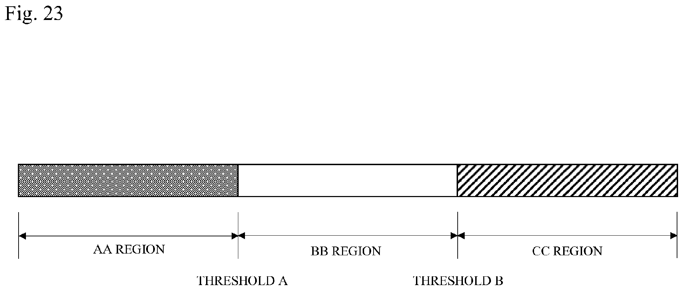

For example, an A threshold and a B threshold are set for the number of times detected, and the region less than the A threshold is set to an AA region, the region equal to or larger than the A threshold and less than the B threshold is set to a BB region, and the region equal to or larger than the B threshold is set to a CC region. In this case, in a case where the number of times detected is in the AA region, it may be determined as the device noise, in a case where the number of times detected is in the BB region, it may be determined as the AC discharge noise, and in a case where the number of times detected is in the CC region, it may be determined as other noise (the DC discharge noise or the like) (see Fig. 23). Note that the determination using the number of times detected may be performed using the total value of the number of times detected, the average number of times detected for each specific time (for example, one cycle), or the like.

In addition, even in a case where the number of times detected is in the BB region, if there is no variation for each cycle and the increase in the number of times detected is proportional linear, it can be discriminated as the device noise or the DC discharge noise. Also in this case, whether it is the device noise or the DC discharge noise may be distinguished by the magnitude of the number of times detected. For example, when the number of times detected is in the BB region close to the AA region but there is no variation for each cycle, and the increase in the number of times detected is proportional linear, it may be determined as the device noise. In addition, when the number of times detected is in the BB region close to the CC region but there is no variation for each cycle, and the increase in the number of times detected is proportional linear, it may be determined as the DC discharge noise.

Moreover, even in a case where the number of times detected is in the AA region, the variation for each cycle and the increase in the number of times detected may be further observed, and whether it is the device noise or the AC discharge noise can be determined.

Similarly, even in a case where the number of times detected is in the CC region, the variation for each cycle and the increase in the number of times detected may be further observed, and whether it is the AC discharge noise or the DC discharge noise can be determined.

As understood from these descriptions, the accuracy of the determination result can be enhanced by using not only the magnitude of the number of times detected but also other information provided by the number of times detected. In addition, the accuracy of the determination result may be enhanced by using information incidentally obtained when the counting unit counts even if the information is not provided by the number of times detected.

Examples of the information incidentally obtained when the counting unit counts include a measurement time during which noise is detected. The measurement time during which noise is detected is a time at a timing when the integrated value of counts tends to increase.

In the case of the device noise, noise may be generated only when the device initially operates, or noise may continue to be generated. On the other hand, in the case of the AC discharge noise, the time during which the noise caused by discharge may be detected and the time during which the noise caused by discharge is not detected appear at regular intervals. In addition, in the case of the DC discharge noise, the time during which the noise caused by discharge is not detected does not appear at regular intervals. For this reason, the noise measurement time is affected by the type of noise. Therefore, it is preferable to set a threshold for the noise measurement time.

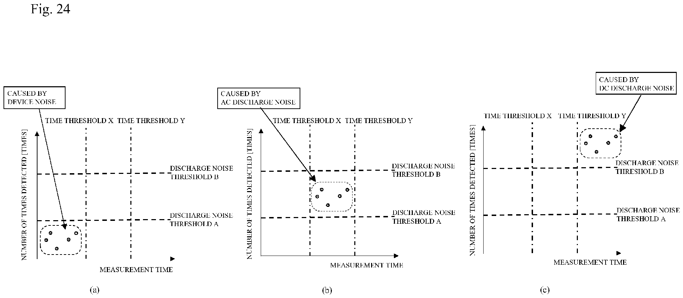

Here, an example of the relationship among the type of noise, the number of times detected, and the noise measurement time will be described. Fig. 24 illustrates an example of the relationship between the number of times detected and the noise measurement time in the device noise, the AC discharge noise, and the DC discharge noise. Note that, in this example, the noise measurement period is set to the time during which noise is measured in five cycles (five cycles of the voltage or current on which noise is superimposed), and the number of times detected counted within the noise measurement time is plotted. Needless to say, the reference period does not need to be five cycles.

Furthermore, in this example, a plurality of pieces of data of the noise measurement time and the number of times detected under the conditions described above are acquired (see Fig. 24), and the type of noise can be determined using the plurality of pieces of acquired data. For the determination of the type of noise, it is not necessary to use all the acquired data. Here, the accuracy of determination of the type of noise can be enhanced by using a plurality of pieces of data. For example, it is preferable to set such that when the acquired data satisfies the conditions a predetermined consecutive number of times, it is determined that the corresponding type of noise is generated.

In the example illustrated in (a) of Fig. 24, data acquired by generation of the device noise is illustrated. In this example, the acquired number of times detected is all smaller than the set threshold A. Furthermore, all the acquired noise measurement times are smaller than a set threshold X.

It is preferable to determine whether or not it is the device noise by confirming whether or not the state where "the acquired number of times detected is smaller than the threshold A, and the acquired noise measurement time is smaller than the threshold X" has occurred a predetermined consecutive number of times. Here, it is also possible to set other conditions such as determining whether or not it is the device noise by confirming whether or not one of the state where "the acquired number of times detected is smaller than the threshold A" and the state where "the acquired noise measurement time is smaller than the threshold X" has occurred a plurality of times.

In the example illustrated in (b) of Fig. 24, data acquired by generation of the AC discharge noise is illustrated. In this example, the acquired number of times detected is all larger than the set threshold A and smaller than the threshold B. Furthermore, all the acquired noise measurement times are larger than the set threshold X and smaller than a set threshold Y.

It is preferable to determine whether or not it is the AC discharge noise by confirming whether or not the state where "the acquired number of times detected is equal to or larger than the threshold A and less than the threshold B, and the acquired noise measurement time is equal to or larger than the threshold X and is less than the threshold Y" has occurred a predetermined consecutive number of times. Here, other conditions such as "the acquired number of times detected is equal to or larger than the threshold A, and the acquired noise measurement time is equal to or larger than the threshold X and is less than the threshold Y" and "the acquired number of times detected is equal to or larger than the threshold A and is less than the threshold B, and the acquired noise measurement time is equal to or larger than the threshold X" can be set.

In the example illustrated in (c) of Fig. 24, data acquired by generation of the DC discharge noise is illustrated. In this example, the acquired number of times detected is all larger than the set threshold B. Furthermore, all the acquired noise measurement times are larger than the set threshold Y.

It is preferable to determine whether or not it is the DC discharge noise by confirming whether or not the state where "the acquired number of times detected is equal to or larger than the threshold B, and the acquired noise measurement time is equal to or larger than the threshold Y" has occurred a predetermined consecutive number of times. Here, it is also possible to set other conditions such as determining whether or not it is the DC discharge noise by confirming whether or not one of the state where "the acquired number of times detected is equal to or larger than the threshold B" and the state where "the acquired noise measurement time is equal to or larger than the threshold Y" has occurred a plurality of times.

If whether the discharge noise is generated or not is only determined, the state where "the acquired number of times detected is equal to or larger than the threshold A, and the acquired noise measurement time is equal to or larger than the threshold X" can be used as a determination condition. Needless to say, the state where " one of the state where the acquired number of times detected is equal to or larger than the threshold A and the state where the acquired noise measurement time is equal to or larger than the threshold X has occurred a predetermined consecutive number of times" can be used as a determination condition.

As understood from these descriptions, it is preferable that at least one or more thresholds for the number of times detected measured by the counting unit and at least one or more thresholds for the count measurement time measured by the counting unit be provided, and the arithmetic processing unit can determine the presence or absence of the noise caused by discharge in the electric circuit using the threshold for the number of times detected and the threshold for the count measurement time.

Note that, in a case where the type of discharge is determined using a plurality of pieces of data, the determination may be performed using an average value or a median value. In this case, the influence of irregular measurement results can be suppressed.

Meanwhile, the discharge detection unit detects high-frequency noise generated by spark discharge. However, the high-frequency noise has a feature of attenuating as the wiring length of the electric circuit is longer. When the detection determination is made in consideration of such an attenuation, the magnitude of actual discharge can be estimated even if discharge occurs at a distant place. In addition, the discharge detection unit according to the present invention can be electrically connected to a distribution board including a plurality of branch breakers 52. By configuring a power distribution system 3 in this manner, it is possible to monitor the power distribution system of the entire building.

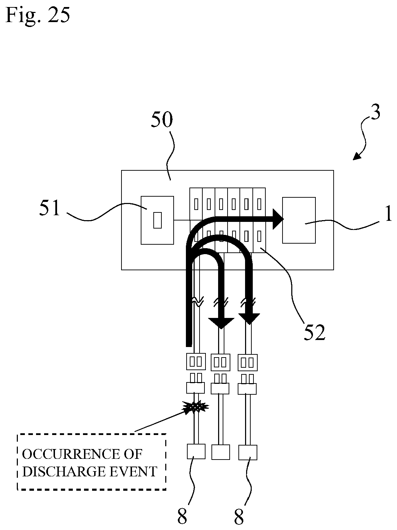

In studying such a matter, it has been found that the noise detected by the discharge detection unit tends to depend on the number of the branch breakers 52. This is considered to be because noise is dispersed and the noise detected by the discharge detection unit is dispersed (see Fig. 25). Dispersion of the discharge noise affects the number of times detected obtained by the counting unit. That is, it has been found that the number of the branch breakers 52 (the number of circuits) affects the number of times detected measured by the counting unit.

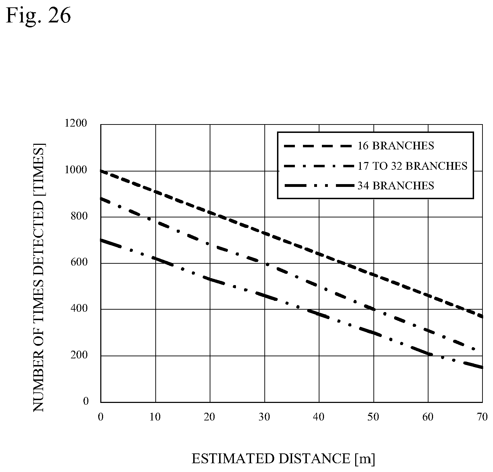

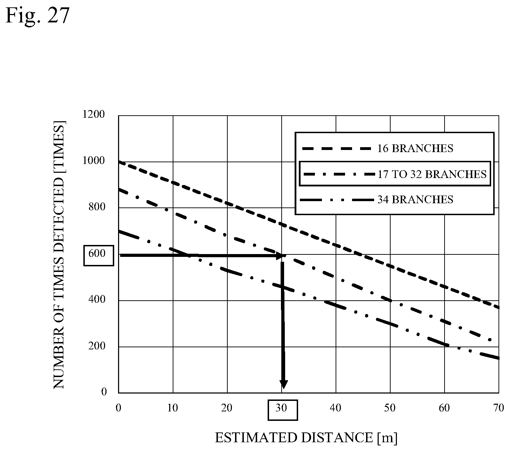

Although the discharge noise itself attenuates depending on not only by the number of circuits but also the distance, it has been found that there is a relationship between the number of the branch breakers 52, the number of times detected, and the estimated distance (see Fig. 26). In this manner, when the relationship among the number of the branch breakers 52, the number of times detected, and the estimated distance is derived from an empirical value or the like, it is possible to estimate the distance between the place where the discharge noise is generated and the discharge detection by using the relationship (see Fig. 27).

The example illustrated in Fig. 27 is an example in which the number of times detected by the counting unit is 600 and the number of the branch breakers 52 is 25. It can be found from the number of the branch breakers 52 that it is only required to check the information indicated by the alternate long and short dash line, and it can be seen that a portion of the information indicated by the alternate long and short dash line in which the number of times detected is 600 is a portion in which it can be estimated that the estimated distance is 30 m. In this way, it can be estimated that the distance between the discharge detection unit and the place where the discharge event has occurred is 30 m.

In order to enable such a configuration, it is preferable to include an occurrence place estimation unit that estimates the occurrence place of the discharge event from the number of the branch breakers 52 and the number of times detected by the counting unit.

In addition, in order to cause such an occurrence place estimation unit to function, information of the number of the branch breakers 52 is required. The number of the branch breakers 52 may be directly input by a user or the like, or may be derived from some information. In the former case, it is only required to prepare a switch input unit capable of inputting the information of the number of the branch breakers 52. In the latter case, it is only required to prepare a switch estimation unit capable of deriving the information of the number of the branch breakers 52 by an arithmetic operation.

The switch input unit is, for example, a dip switch formed on the surface of the discharge detection unit. In addition, the switch estimation unit is only required to be, for example, a unit that can perform an arithmetic operation to collect information such as the rated current of the branch breaker 52 and the rated current of the main breaker and to estimate the number of the branch breakers 52.

As can be understood from these descriptions, it is preferable to provide the power distribution system 3 in which the discharge detection unit is electrically connected to the plurality of branch breakers 52, in which the relationship between the number of times detected and the occurrence place of the discharge event is stored so as to correspond to the number of the branch breakers 52, and the power distribution system 3 preferably includes the switch input unit that inputs information of the number of the branch breakers 52 or the switch estimation unit that estimates the number of the branch breakers 52, and includes the occurrence place estimation unit that can estimate the occurrence place of the discharge event using the number of the branch breakers 52 input or estimated and the number of times detected measured by the counting unit.

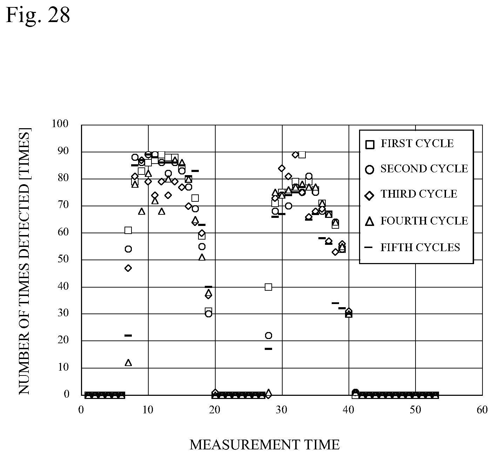

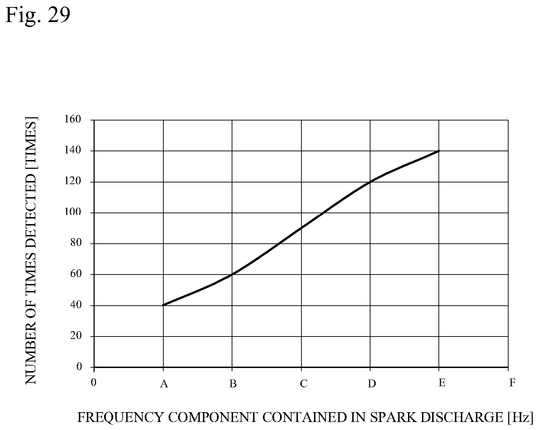

Meanwhile, when looking at the number of times detected obtained at each timing to obtain the integrated value, it can be found that the number of times detected varies. For example, even in the case illustrated in Fig. 20 when viewed from the integrated value in one cycle of the voltage or current on which noise is superimposed, Fig. 28 is obtained when viewed from the number of times detected per unit time during the cycle. In addition, when data of the number of times detected and frequencies (here, only high frequencies) contained in the discharge is collected, it has been found that there is a relationship between the number of times detected and frequencies contained in the discharge. More specifically, as understood from Fig. 29, it has been found that there is a substantially proportional relationship between the number of times detected and frequencies contained in the discharge.

By using this relationship, the frequency of the noise caused by the discharge event can be estimated from the number of times detected measured by the counting unit. For example, the dominant frequency or the maximum frequency can be estimated.

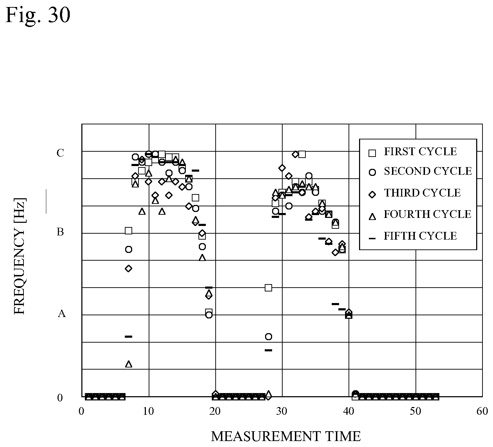

Here, an example will be described in which, in a case where the information illustrated in Fig. 29 is obtained from the empirical value, the information is used to specify the frequency. For example, in a case where the number of times detected in a specific duration period is about 90, it can be estimated that the frequency component is C (Hz). By performing such an operation, the diagram illustrated in Fig. 28 can be rewritten as illustrated in Fig. 30. Note that in the example illustrated in Fig. 28, the vertical axis represents the number of times detected, and the horizontal axis represents time. On the other hand, in the example illustrated in Fig. 30, the vertical axis represents frequency, and the horizontal axis represents time.

It is possible to recognize the dominant frequency band and the maximum frequency from Fig. 30. Note that, if the frequency band can be specified, it is possible to estimate whether the noise is derived from a device such as a home appliance or derived from a discharge event.

In order to enable such an operation, it is preferable to include a frequency estimation unit used for frequency estimation. More specifically, it is preferable to have a configuration in which the relationship between the number of times detected and the frequency is stored, and a frequency estimation unit that can specify the frequency of the discharge event using the number of times detected measured by the counting unit is included. Note that it is preferable that the frequency estimation unit can estimate the dominant frequency and the maximum frequency.

Note that, in the example illustrated in Fig. 30, the data is distributed in a manner that there are two peaks, which is because a peak appears twice in one cycle of a sine wave. In this example, both the time period of the positive peak (the time period of the first peak) and the time period of the negative peak (the time period of the second peak) have a similar frequency distribution, but there may be a case where such a distribution is not obtained. In this case, it is preferable to determine the discharge event using data of the frequency band having larger numerical values.

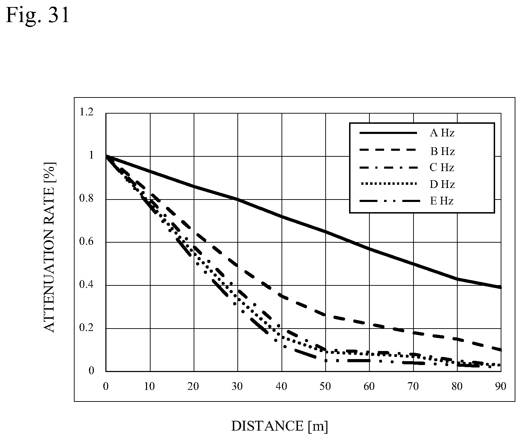

Meanwhile, the noise caused by the discharge event attenuates depending on the distance between the place where the discharge event has occurred and the place where the noise is measured. The manner of attenuation differs for each frequency band. Here, if the frequency is specified, the relationship between "the distance between the place where the discharge event has occurred and the place where the noise is measured" and "the attenuation rate" can be derived from an empirical rule (see Fig. 31).

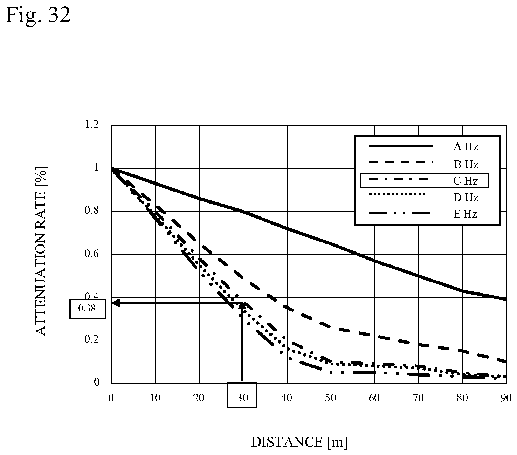

For this reason, if "the distance between the place where the discharge event has occurred and the place where the noise is measured" and "the frequency" are known, the attenuation rate can be estimated (see Fig. 32). If the attenuation rate can be estimated, even in a case where a highly dangerous discharge occurs at a place slightly away from the discharge detection unit, it can be detected.

On the other hand, by analyzing the number of times detected as described above, "the distance between the place where the discharge event has occurred and the place where the noise is measured" and "the frequency" can be estimated (see Figs. 26 and 29). Note that Figs. 20 to 22, 24, and 26 to 32 are diagrams illustrating the relationship between the number of times detected and the frequency, the relationship between the number of times detected and the estimated distance, and the like. These are merely examples, and the numerical values of the number of times detected, the frequency, and the estimated distance may be different.

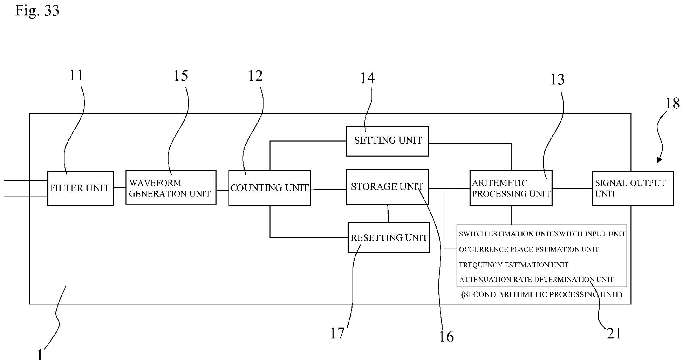

In order to enable such an operation, in the example illustrated in Fig. 33, a second arithmetic processing unit 21 is provided. The second arithmetic processing unit 21 illustrated in Fig. 33 includes the switch estimation unit or the switch input unit. The second arithmetic processing unit 21 also includes the occurrence place estimation unit, the frequency estimation unit, and an attenuation rate specifying unit.

The switch estimation unit, the switch input unit, the occurrence place estimation unit, the frequency estimation unit, and the attenuation rate specifying unit do not need to be included in the second arithmetic processing unit 21. For example, some or all of them may be provided at a location different from the discharge detection unit.

As understood from these descriptions, it is preferable that the power distribution system 3 have a configuration in which the relationship between the distance of occurrence and the attenuation rate is stored for each frequency, and the occurrence place estimation unit and the attenuation rate specifying unit capable of specifying the attenuation rate of discharge noise from the distance of occurrence estimated by the frequency estimation unit and the frequency estimation unit are included.

Although the present invention has been described by taking the embodiment as an example, the present invention is not limited to the above embodiment, and various aspects can be adopted. For example, a part of the order of determination logics can be replaced, a part thereof can be deleted, or a part thereof can be newly added.

### REFERENCE SIGNS LIST

- 1: discharge detection unit
- 6: electric circuit
- 8: load
- 11: filter unit
- 12: counting unit
- 13: arithmetic processing unit
- 14: setting unit
- 52: branch breaker

## Claims

1. A discharge detection unit that can detect noise superimposed on the voltage or current of the electric circuit to which a load is connected by being electrically connected to the electric circuit to which the load is connected, the discharge detection unit comprising:
a filter unit that can output a waveform of passed noise in a high frequency band without passing noise at a commercial frequency band and in a low frequency band by cutting noise of a predetermined frequency or lower superimposed on the voltage or current of the electric circuit;
a counting unit that can calculate the number of waveform detections in a predetermined time from the waveform passed through the filter unit; and
an arithmetic processing unit that can determine the presence or absence of noise caused by discharge in the electric circuit using the number of times detected calculated by the counting unit.

2. The discharge detection unit according to claim 1, wherein in a case where any one of device noise caused by the load and the discharge noise in the electric circuit is generated, it is possible to determine which of device noise and discharge noise is generated by using the number of times detected obtained by the counting unit.

3. The discharge detection unit according to claim 2, comprising a setting unit that can set the time during which the number of waveform detections is calculated by the counting unit.

4. The discharge detection unit according to claim 3, wherein the number of times detected is determined a plurality of times, and in a case where it can be confirmed that the number of times detected is larger than a set number of times for a predetermined consecutive number of times, it can be determined that the noise caused by the discharge event is generated.

5. The discharge detection unit according to any one of claims 1 to 4, wherein the cause of the discharge event can be specified by using both the regularity of the appearance of noise during the long period, which is one cycle or more, or regularity of output during the long period, which is one cycle or more, and the number of times detected by the counting unit during the short period, which is shorter than the long period.

6. The discharge detection unit according to claim 1, wherein an upper limit on the number of times detected by the counting unit is set, and in a case where the number of times detected exceeding the upper limit is detected, it can be determined as noise caused by the electromagnetic wave.

7. The discharge detection unit according to claim 1, wherein the number of times detected measured by the counting unit can be acquired for each cycle of the voltage or current on which noise is superimposed, and the arithmetic processing unit can determine the presence or absence of the noise caused by discharge in the electric circuit using at least one or more of the increasing trend of the number of times detected for each cycle and the variation in the increase of the number of times detected for each cycle.

8. The discharge detection unit according to claim 1 comprising at least one or more thresholds for the number of times detected measured by the counting unit and at least one or more thresholds for the count measurement time measured by the counting unit, wherein
an arithmetic processing unit can determine the presence or absence of the noise caused by discharge in the electric circuit using the threshold for the number of times detected and the threshold for the count measurement time.

9. A power distribution system in which the discharge detection unit according to claim 1 is electrically connected to the plurality of branch breakers, and
the relationship between the number of times detected and the occurrence place of the discharge event is stored so as to correspond to the number of branch breakers, the power distribution system comprising:
the switch input unit that inputs information of the number of branch breakers or a switch estimation unit that estimates the number of branch breakers; and
the occurrence place estimation unit that can estimate the occurrence place of the discharge event using the number of branch breakers input or estimated and the number of times detected measured by the counting unit.

10. The power distribution system according to claim 9, wherein the relationship between the number of times detected and the frequency is stored, and
the power distribution system comprising a frequency estimation unit that can specify the frequency of the discharge event using the number of times detected measured by the counting unit.

11. The power distribution system according to claim 10, wherein the relationship between the distance between the discharge detection unit and the occurrence place of a discharge event and an attenuation rate is stored for each frequency, and
the power distribution system comprising: the occurrence place estimation unit; and the attenuation rate specifying unit that can specify the attenuation rate of discharge noise from the distance of occurrence estimated by the frequency estimation unit and the frequency estimation unit.
